# EUROPÄISCHE PATENTSCHRIFT

(11) **EP 2 684 227 B1**
(45) Veröffentlichungstag und Bekanntmachung des Hinweises auf die Patenterteilung: **22.04.2015**
(21) Anmeldenummer: 12708530.6
(22) Anmeldetag: 06.03.2012
(51) Int. Cl.: H01L 41/083, H04R 17/00

(54) **SCHICHTVERBUND MIT ELEKTROAKTIVEN SCHICHTEN**
LAYER COMPOSITE COMPRISING ELECTROACTIVE LAYERS
COMPOSITE STRATIFIÉ À COUCHES ÉLECTROACTIVES

(30) Priorität: 07.03.2011 EP 11157139
(43) Veröffentlichungstag der Anmeldung: 15.01.2014
(73) Patentinhaber: Bayer Intellectual Property GmbH, 40789 Monheim am Rhein (DE); Hochschule Ostwestfalen-Lippe, 32657 Lemgo (DE); Insta Elektro GmbH, 58509 Lüdenscheid (DE); Universität Potsdam, 14469 Potsdam (DE)
(72) Erfinder: GERHARD, Reimund, 10623 Berlin (DE); WIRGES, Werner, 14532 Kleinmachnow (DE); MAAS, Jürgen, 32756 Detmold (DE); GRAF, Christian, 33100 Paderborn (DE); MUNDINGER, Harald, 58849 Herscheid (DE); JENNINGER, Werner, deceased (DE)
(74) Vertreter: Schubert, Klemens
(86) Internationale Anmeldenummer: PCT/EP2012/053813
(87) Internationale Veröffentlichungsnummer: WO 2012/120009

(56) Entgegenhaltungen:
- DE-A1-102009 030 693
- US-A1- 2002 064 001

## Beschreibung

Die Erfindung betrifft einen Schichtverbund, umfassend mindestens zwei zwischen einer ersten elektrisch leitfähigen Schicht und einer zweiten elektrisch leitfähigen Schicht angeordnete elektroaktive Schichten, wobei zwischen den mindestens zwei elektroaktiven Schichten zumindest eine elektrisch leitfähige Teilschicht angeordnet ist, und wobei mindestens eine der mindestens zwei elektroaktiven Schichten eine Piezoschicht ist. Darüber hinaus betrifft die Erfindung eine elektromechanische Wandlervorrichtung umfassend diesen Schichtverbund und ein Verfahren zur Herstellung eines Schichtverbunds.

Kunststoffverbundstoffe werden in einer Vielzahl von Anwendungen eingesetzt. Beispielsweise wird ein entsprechender Schichtverbund als Verpackungsmaterial, Isolationsmaterial oder als Konstruktionsmaterial verwendet. Neben diesem herkömmlichen Einsatzzweck, werden Schichtverbunde vermehrt als aktive Komponenten in Sensoranwendungen oder zur Energiegewinnung bzw. Energiewandlung, dem so genannten Energy Harvesting, eingesetzt.

Beispielsweise offenbart die WO 2010/066347 A2 einen Schichtverbund mit mehreren Piezoschichten, also Schichten aus einem piezoelektrischen Material. Ein piezoelektrisches Material kann verwendet werden, um eine auf den Schichtverbund wirkende mechanische Kraftänderung linear in ein elektrisches Signal zu wandeln. Durch die Fähigkeit, eine mechanische Kraftänderung in eine elektrische Größe, wie einen Strom, eine Spannung oder Energie, zu wandeln, sind Piezoschichten für eine Sensoranwendung oder Energy Harvesting geeignet.

Ein Schichtverbund wird heutzutage beispielsweise in strukturierten Drucksensoren für Tastaturen oder Touchpads, Beschleunigungssensoren, Mikrofonen, Lautsprechern, Ultraschallwandlern für Anwendungen in der Medizintechnik, der Meerestechnik oder zur Materialprüfung verwendet.

Aus der Europäischen Patentschrift EP 1 312 171 B1 ist beispielsweise ein Hochfrequenzsender mit einem piezoelektrischen Element als Wandlervorrichtung bekannt. Hierbei wird die auf das piezoelektrische Element wirkende mechanische Kraftänderung in elektrische Energie gewandelt und für einen autarken Betrieb des Hochfrequenzsenders verwendet.

Nachteilig bei dem Stand der Technik ist jedoch, dass ein Schichtverbund mit Piezoschichten, die eine erhöhte Piezokonstante aufweisen, zwar für eine Sensoranwendung und Energy Harvesting geeignet ist. Jedoch eignet sich eine entsprechende Piezoschicht infolge zu geringer möglicher Stellwege nur bedingt für eine Aktoranwendung.

Daher liegt der vorliegenden Erfindung die Aufgabe zugrunde, einen Schichtverbund zur Verfügung zu stellen, der nicht nur für die Anwendungen Sensorik und Energy Harvesting sondern auch für die Anwendung Aktorik geeignet ist.

Die zuvor hergeleitete und aufgezeigte Aufgabe wird gemäß einem ersten Aspekt der Erfindung bei einem Schichtverbund umfassend mindestens zwei zwischen einer ersten elektrisch leitfähigen Schicht und einer zweiten elektrisch leitfähigen Schicht angeordnete elektroaktive Schichten, wobei zwischen den mindestens zwei elektroaktiven Schichten zumindest eine elektrisch leitfähige Teilschicht angeordnet ist, und wobei mindestens eine der mindestens zwei elektroaktiven Schichten eine Piezoschicht ist, dadurch gelöst, dass mindestens eine weitere der mindestens zwei elektroaktiven Schichten eine dielektrische Elastomerschicht ist.

Im Gegensatz zum Stand der Technik werden gemäß der Lehre der Erfindung durch zumindest zwei unterschiedliche elektroaktive Schichtarten in einem einzigen Schichtverbund gemäß der Erfindung die Funktionen Sensorik, Aktorik und Energy Harvesting vereint.

Die Piezoschicht kann beispielsweise aus einem geeigneten Piezopolymer gebildet und eine Piezopolymerfolie sein. Gemäß einer bevorzugten Ausführungsform kann die Piezoschicht eine Ferroelektretschicht, wie eine Ferroelektretfolie, sein. Die Piezoschicht kann dauerhaft piezoelektrische Eigenschaften aufweisen. Beispielsweise können diese durch eine Aufladung oder Polung der Piezoschicht erzeugt werden. Eine Piezoschicht kann aufgrund einer erhöhten Piezokonstante insbesondere für eine Sensoranwendung und/oder für Energy Harvesting eingesetzt werden. Beispielsweise können Piezoschichten mit einer Piezokonstante von bis zu 1000 pC/N bereitgestellt werden.

Ferner umfasst der Schichtverbund gemäß der Erfindung zumindest eine dielektrische Elastomerschicht. Eine dielektrische Elastomerschicht weist vorzugsweise eine relativ hohe Dielektrizitätszahl auf. Darüber hinaus weist eine dielektrische Elastomerschicht vorzugsweise eine niedrige mechanische Steifigkeit auf. Diese Eigenschaften führen zu möglichen Dehnungswerten von bis zu ca. 300 %. Eine dielektrische Elastomerschicht kann insbesondere für eine Aktoranwendung eingesetzt werden.

Zwischen der Piezoschicht und der dielektrischen Elastomerschicht ist zumindest eine elektrisch leitfähige Teilschicht angeordnet. Unter einer Teilschicht ist zu verstehen, dass elektrisch leitendes Material nur teilweise zwischen den mindestens zwei elektroaktiven Schichten vorhanden ist. Beispielsweise kann eine strukturierte bzw. segmentierte Schicht gebildet werden. Es versteht sich, dass die Schicht auch Vollschicht sein kann.

Darüber hinaus ist an der Oberseite des Schichtverbunds eine elektrisch leitfähige Schicht und an der Unterseite des Schichtverbunds eine elektrisch leitfähige Schicht angeordnet.

Die elektrisch leitfähigen Schichten können insbesondere als Elektrode ausgebildet sein. Es versteht sich, dass die Unterseite bzw. die Oberseite nur teilweise mit einer elektrisch leitfähigen Schicht beschichtet sein kann.

Vorzugsweise kann eine elektrisch leitfähige Schicht aus einem Material gebildet sein, das ausgewählt ist aus der Gruppe umfassend Metalle, Metalllegierungen, leitfähige Oligo- oder Polymere, leitfähige Oxide und/oder mit leitfähigen Füllstoffen gefüllte Polymere.

Durch die erfindungsgemäße Kombination mindestens einer dielektrischen Elastomerschicht und mindestens einer Piezoschicht können die spezifischen Eigenschaften der jeweiligen Schichtart in einem Schichtverbund vereinigt werden. Das Ergebnis ist ein hybrider, kompakter Schichtverbund, welcher die Funktionen Sensorik, Aktorik und Energy Harvesting aufweist.

Grundsätzlich kann der Schichtverbund eine Vielzahl von elektroaktiven Schichten aufweisen, so lange zumindest eine Piezoschicht und zumindest eine dielektrische Elastomerschicht angeordnet sind. Gemäß einer ersten Ausführungsform des Schichtverbunds der Erfindung kann mindestens eine weitere Piezoschicht zwischen der ersten elektrisch leitfähigen Schicht und der zweiten elektrisch leitfähigen Schicht angeordnet sein. Durch die Anordnung von zwei oder mehr Piezoschichten kann beispielsweise mehr mechanische Energie in elektrische Energie gewandelt werden. Die Piezoschichten können aus dem gleichen oder unterschiedlichen Material gebildet sein. Vorzugsweise kann es sich um Ferroelektretschichten handeln.

Alternativ oder zusätzlich kann mindestens eine weitere dielektrische Elastomerschicht zwischen der ersten elektrisch leitfähigen Schicht und der zweiten elektrisch leitfähigen Schicht angeordnet sein. Hierbei kann bei einer Aktoranwendung die mögliche Dickenänderung eines Schichtverbunds angepasst und insbesondere vergrößert werden. Es sei angemerkt, dass bei mehreren elektroaktiven Schichten bevorzugt zwischen sämtlichen benachbarten Schichten zumindest teilweise eine elektrisch leitende Schicht angeordnet sein kann.

Die Piezoschicht kann als geschäumte Polymerfolie oder als Mehrschichtsystem aus Polymerfolien oder Polymergeweben ausgebildet sein und eine zelluläre Hohlraumstruktur umfassen. Darüber hinaus kann gemäß einer bevorzugten Ausführungsform die Piezoschicht aus einer Polymerschichtstruktur gebildet sein. Die Polymerschichtstruktur kann Hohlräume umfassen. Beispielsweise können die Hohlräume ein Gas umfassen, das ausgewählt ist aus der Gruppe umfassend Stickstoff, Distickstoffmonoxid und/oder Schwefelhexafluorid. Strukturierte Piezoschichten können zumindest zwei geschlossene äußere Schichten und beispielsweise eine poröse oder perforierte Mittelschicht umfassen.

Nach einer elektrischen Aufladung oder Polung der Piezoschicht können elektrische Ladungen unterschiedlicher Polarität auf den gegenüberliegenden Oberflächen der Hohlräume verteilt sein. Jeder Hohlraum kann einen Dipol bilden. Wird eine mechanische Kraft auf eine Piezoschicht ausgeübt, so verändert sich die Dipolgröße und damit das Dipolmoment. Ein Stromfluss zwischen zwei Elektroden, die auf den beiden Oberflächen der Piezoschicht angebracht sind, wird erzeugt. Eine Piezoschicht mit einer entsprechenden Polymerschichtstruktur ist besonders für eine Sensoranwendung und Energy Harvesting geeignet.

Vorteilhafterweise kann gemäß einer weiteren Ausführungsform des erfindungsgemäßen Schichtverbunds die Piezoschicht ein Material umfassen, das ausgewählt ist aus der Gruppe umfassend Polycarbonat, perfluorierte oder teilfluorierte Polymere und CoPolymere, Polytetrafluorethylen, Fluorethylenpropylen, Perfluoralkoxyethylen, Polyester, Polyethylenterephthalat, Polyethylennaphthalat, Polyimid, Polyetherimid, Polyether, Polymethyl(meth)acrylat, Cyclo-Olefin-Polymere, Cyclo-Olefin-Copolymere und/oder Polyolefine.

Ferner kann die dielektrische Elastomerschicht gemäß einer bevorzugten Ausführungsform der Erfindung ein Material umfassen, das beispielsweise ausgewählt ist aus der Gruppe umfassend Polyurethan-Elastomere, Silikon-Elastomere und/oder Acrylat-Elastomere.

Ein weiterer Aspekt der Erfindung ist eine elektromechanische Wandlervorrichtung umfassend einen zuvor beschriebenen Schichtverbund. Die erfindungsgemäße Wandlervorrichtung kann insbesondere konfiguriert sein, um eine auf sie wirkende mechanische Kraftänderung in elektrische Energie bzw. in ein elektrisches Signal zu wandeln und um bei Anlegung eines elektrischen Signals, insbesondere eines elektrischen Felds, die geometrische Form entsprechend zu ändern. Wie bereits ausgeführt wurde, wird in einer elektromechanischen Wandlervorrichtung mit einem zuvor beschriebenen Schichtverbund die Funktionen Aktorik, Sensorik und Energy Harvesting in einer einzigen Vorrichtung vereint. Es versteht sich, dass eine elektromechanische Wandlervorrichtung zwei oder mehr Schichtverbunde aufweisen kann.

Gemäß einer ersten Ausführungsform der erfindungsgemäßen elektromechanischen Wandlervorrichtung kann der Schichtverbund mit einer Bedienoberfläche verbunden sein, derart, dass eine auf die Bedienoberfläche wirkende mechanische Kraftänderung in ein elektrisches Signal umgewandelt wird. Mit anderen Worten kann eine Sensorfunktion bereitgestellt werden. Die Betätigung der Bedienfläche führt zu einer Formänderung des Schichtverbunds. Die Formänderung des Schichtverbunds erzeugt beispielsweise eine Spannung, die durch geeignete Mittel detektiert werden kann.

Alternativ oder zusätzlich kann der Schichtverbund mit einer Bedienoberfläche verbunden sein, derart, dass eine auf die Bedienoberfläche wirkende mechanische Kraftänderung in elektrische Energie wandelbar ist. Bei der Bedienoberfläche kann es sich insbesondere um eine Fläche handeln, wie beispielsweise die Schaltfläche eines Schalters, die von einem Benutzer aktuiert werden kann. Die Bedienfläche kann derart mit dem Schichtverbund, insbesondere mit einer Elektrode des Schichtverbunds verbunden sein, dass die auf die Bedienfläche wirkende Kraft auch auf den Schichtverbund wirkt. Die mechanische Kraftänderung, beispielsweise ein Druck durch einen Finger eines Benutzers, kann dann in elektrische Energie oder in ein elektrisches Signal gewandelt werden.

Um ein erzeugtes elektrisches Signal weiterzuverarbeiten oder erzeugte elektrische Energie zu nutzen, kann gemäß einer weiteren Ausführungsform der erfindungsgemäßen elektromechanischen Wandlervorrichtung eine mit dem Schichtverbund elektrisch verbindbare Schaltungseinrichtung vorgesehen sein. Die Schaltungseinrichtung kann in geeigneter Weise mit den elektrisch leitfähigen Schichten verbunden sein. Die Schaltungseinrichtung kann analoge und/oder digitale Komponenten aufweisen, um ein elektrisches Signal, wie eine Spannung oder einen Strom weiterzuverarbeiten, und/oder elektrische Energie zumindest zeitweise zu speichern. Als Speicher kann beispielsweise ein geeignetes kapazitives Element in der Schaltungseinrichtung vorgesehen sein. Ferner kann die Schaltungseinrichtung konfiguriert sein, dass zumindest einige Elektroden des Schichtverbunds mit einer Spannung beaufschlagt werden können. Es versteht sich, dass die Schaltungseinrichtung entsprechend der gewünschten Funktionalität der elektromechanischen Wandlervorrichtung ausgebildet werden kann.

Gemäß einer bevorzugten Ausführungsform der erfindungsgemäßen elektromechanischen Vorrichtung kann vorgesehen sein, dass die Schaltungseinrichtung autark durch die in elektrische Energie gewandelte mechanische Energie betreibbar ist. Mit anderen Worten kann die Schaltungseinrichtung ausschließlich mit der auf die Vorrichtung wirkenden mechanischen Kraftänderung insbesondere unabhängig von einer weiteren Energieversorgung betrieben werden. Es ist kein zusätzlicher Energiespeicher zur zusätzlichen Versorgung mit Energie erforderlich. Es versteht sich jedoch, dass Energiespeicher zur Speicherung, insbesondere Zwischenspeicherung der durch die mechanische Kraftänderung erzeugten elektrischen Energie vorgesehen sein können. Beispielsweise kann die erzeugte elektrische Energie in einer Speichereinrichtung, wie einem Kondensator, einem Superkondensator und/oder einer Batterie, gesammelt werden. Dies kann erforderlich sein, wenn durch eine einmalige Betätigung der elektromechanischen Wandlervorrichtung nicht genügend Energie bereitgestellt werden kann, sondern eine mehrmalige Betätigung notwendig ist. Wenn ausreichend Energie gesammelt worden ist, kann eine gewünschte Aktion durchgeführt werden.

Alternativ kann die Schaltungseinrichtung eine Energieversorgung umfassen. Eine zusätzliche Energieversorgung z.B. in Form eines Energiespeichers kann erforderlich sein, wenn die durch den Schichtverbund erzeugbare elektrische Energie nicht ausreichend ist, eine oder mehrere gewünschte Aktionen auszuführen. Beispielsweise kann die Energie aufgrund einer vorgegebenen kompakten und insbesondere flachen Ausführung des Schichtverbunds und/oder aufgrund der auszuführenden Funktion nicht ausreichen.

Vorzugsweise kann die Schaltungseinrichtung derart konfiguriert sein, dass die Schaltungseinrichtung durch die in elektrische Energie gewandelte mechanische Energie aus einem Ruhezustand in einen Betriebszustand versetzbar ist. Mit anderen Worten kann die Schaltungseinrichtung aus einem Schlafzustand aufgeweckt werden. Dann kann sie von dem Energiespeicher, wie einer Batterie, mit Energie versorgt werden. Nach Ausführung der zumindest einen Aktion kann die Schaltungseinrichtung (automatisch) wieder in den Ruhezustand versetzt werden. Hierdurch kann die Lebensdauer eines Energiespeichers signifikant verlängert werden. Beispielsweise kann eine Lebensdauer von 20 Jahren erzielt werden (z.B. bei Einsatz von Lithium-Mangandioxid-Zellen). Umfangreichere Schaltungseinrichtung umfassend einen Prozessor, Speicher und dergleichen können wartungsarm mit einer langen Lebensdauer realisiert werden.

Gemäß einer vorteilhaften Ausführungsform kann die Schaltungseinrichtung ein Sendeelement zum Senden eines Signals umfassen. Insbesondere kann es sich um ein Sendeelement zum Aussenden eines Funksignals, wie eines kurzen Impulses, eines Datentelegramms oder dergleichen, handeln. Ein Sendeelement kann z.B. eine Antennenanordnung aufweisen. Beispielsweise kann ein Funksignal an einen entfernten Empfänger gesendet werden. Dieser kann einen Aktor umfassen und beispielsweise einen Verbraucher, wie eine Heizung oder eine Leuchtvorrichtung, ansteuern.

Ferner kann das Funksignal beispielsweise eine eindeutige Kennung aufweisen, die eine Identifizierung des Senders, also der elektromechanischen Wandlervorrichtung, ermöglicht. Eine entsprechende Vorrichtung kann beispielsweise in einem Sicherheitssystem oder Personenüberwachungssystem eingesetzt werden. Anhand der Kennung kann eine Lokalisierung eines Bedieners erfolgen.

Bei einer Wandlervorrichtung ist es möglich, mittels eines mechanischen Drucks eine Aktion auszulösen. Jedoch kann sich ein Benutzer, insbesondere bei sehr kurzen Betätigungswegen der Wandlervorrichtung, nicht sicher sein, ob tatsächlich seine Berührung erfasst wurde. Um einem Benutzer eine Rückmeldung darüber zu geben, dass eine Aktuierung der elektromechanischen Wandlervorrichtung tatsächlich ausgelöst worden ist, kann der Schichtverbund der elektromechanischen Wandlervorrichtung gemäß einer bevorzugten Ausführungsform derart ausgebildet sein, dass über die Bedienoberfläche eine taktile Rückmeldung abgegeben wird. Eine taktile Rückmeldung kann beispielsweise durch eine Vibration und/oder einen (Gegen-)Druck gegeben werden.

Gemäß einer weiteren bevorzugten Ausführungsform der erfindungsgemäßen elektromechanischen Wandlervorrichtung kann für eine taktile Rückmeldung zumindest die eine dielektrische Elastomerschicht mit einer Spannung derart beaufschlagt werden, dass eine Dickenänderung der Elastomerschicht von zumindest 0,1 µm, bevorzugt zumindest 10 µm, mit einer vorgebbaren Frequenz erzeugt wird. Es kann ein elektrisches Feld, insbesondere Wechselfeld zumindest an die beiden Elektroden, die an den Oberflächen der zumindest einen dielektrischen Elastomerschicht angeordnet sind, angelegt werden. Es ist erkannt worden, dass bei einer Betätigung der elektromechanischen Wandlervorrichtung z.B. durch einen Finger eines Benutzers die Erzielung einer ausreichenden taktilen Rückmeldung von der Dickenänderung und der Frequenz abhängt. Insbesondere ist erkannt worden, dass im Frequenzbereich zwischen 200 und 250 Hz der menschliche Finger mit einer Wahrnehmungsschwelle von ca. 0,1 µm am empfindlichsten ist. Bei anderen Frequenzbereichen kann eine größere Dickenänderung beispielsweise durch die Anordnung von mehreren dielektrischen Elastomerschichten erreicht werden. Auch bei geringen Betätigungswegen erhält ein Benutzer eine gute taktile Rückmeldung.

Darüber hinaus kann die Bedienoberfläche als ein Segment zur Auslösung einer oder mehrerer Aktionen ausgebildet sein. Gemäß einer anderen Ausführungsform kann die Bedienoberfläche ein erstes Segment zur Auslösung einer ersten Aktion und mindestens ein zweites Segment zur Auslösung einer zweiten Aktion umfassen. Beispielsweise kann jedes Segment mit einem separaten Schichtverbund verbunden sein, um unterschiedlich Aktionen auszulösen. Es versteht sich, dass das Bedienelement auch in drei oder mehr Segmente z.B. zur Ausführung weiterer Aktionen unterteilt werden kann.

Bei der elektromechanischen Wandlereinrichtung kann es sich gemäß einer weiteren Ausführungsform um eine Sensoreinrichtung, wie einer Schaltereinrichtung, handeln. Beispielsweise kann die elektromechanische Wandlereinrichtung ein Tastsensor, ein Flachsensor oder ein Fußbodensensor sein.

Tastsensoren in konventioneller Bauform können bevorzugt mit zwei oder mehr Piezoschichten gebildet sein. Dies ermöglicht Betätigungswege von z.B. bis zu ca. 2 mm. Darüber hinaus ermöglichen zwei oder mehr Piezoschichten Kräfte von z.B. bis zu ca. 5 N. Bei Betätigungswegen von z.B. bis zu ca. 2 mm und Kräften von bis zu ca. 5 N kann mittels einer mechanischen und elektrischen Anpassung eine ausreichend hohe, kurzzeitig zwischengespeicherte, elektrische Energie gewonnen werden, mit deren Hilfe ein autarker Tastsensor, wie ein Funk-Wipptaster, betrieben werden kann.

Flachsensoren können für eine optisch ansprechende und insbesondere flache Ausgestaltung lediglich eine Piezoschicht und eine dielektrische Elastomerschicht aufweisen. Bei derartigen Flachsensoren können (unmerkliche) Betätigungswege von weniger als 500 µm erzielt werden. Ein Flachsensor kann mit einer Kraft von weniger als 1 N betätigt werden. Insbesondere durch die dielektrische Elastomerschicht kann eine taktile Rückmeldung als Bestätigung für eine Bedienung des Flachsensors bereitgestellt werden. Neben einer taktilen Rückmeldung können Rückmeldungen von dem zu aktuierenden Element an den Benutzer übertragen werden. Beispielsweise kann ein Funksignal gesendet werden.

Eine weitere Anwendungsmöglichkeit der elektromechanischen Vorrichtung ist ein Fußbodensensor, wie ein intelligentes Fußbodenelement (smart carpet). Beispielsweise kann die Vorrichtung in Form einer Kachel gebildet sein, welche beispielsweise eine Fläche von 100 cm² oder mehr aufweisen kann. Die Kachel kann ferner eine Tiefe von ca. 1 mm aufweisen. Dieses Fußbodenelement kann insbesondere mehrere Piezoschichten aufweisen. Eine Bedienkraft von ca. 100 N und mehr ist möglich. Hierdurch lassen sich Energiemengen von mehr als 300 µJ erzielen. Neben der Funktion der Energiegewinnung kann der Schichtverbund als Sensorelement zur Lokalisierung eines Bedieners, der z.B. auf eine Kachel tritt, dienen.

Ein Tastsensor, ein Flachsensor oder ein Fußbodensensor kann beispielsweise in einem Gebäudeautomationssystem oder bei der Personenüberwachung, wie der Patientenüberwachung verwendet werden. Die entsprechenden Sensoren können bei einer mechanischen Belastung beispielsweise ein Signal an einen oder mehrere Empfänger aussenden. Das empfangene Signal kann dann weiterverarbeitet werden und eine Aktion, wie beispielsweise ein Alarm ausgelöst werden, oder ein Verbraucher aktiviert oder deaktiviert werden.

Beispielsweise kann eine Vielzahl von Fußbodensensoren in einem Gebäude vorgesehen sein, wobei jedem Sensor eine eindeutige Kennung zugeordnet sein kann. In einem Überwachungssystem können Benutzer dadurch lokalisiert werden, dass durch eine Betätigung eines Sensors dieser an eine Verarbeitungseinrichtung seine Kennung sendet, welche Rückschlüsse auf die Position des Sensors und damit des Bedieners erlaubt.

Sofern die elektrischen Ausgangsgrößen reproduzierbar und langzeitstabil sind und z. B. mit dem Gewicht einer Person oder eines Gegenstandes zusammenhängen, könnte das gemessene "Gewicht" in ein Funktelegramm eingebunden und damit zusätzliche Informationen über Personen oder Fahrzeuge auf einem intelligenten Fußboden erhalten werden. Interessante Anwendung ergeben sich hierbei z.B. in der Gerontotechnik bzw. für alle Formen des AAL (Ambient Assisted Living).

Ein Tastsensor kann auch in einem Schlüssel, wie einem Autoschlüssel oder einem Türschlüssel, verwendet werden, um beispielsweise per Funk eine entsprechende Vorrichtung freizuschalten. Beispielsweise kann ein entsprechender Autoschlüssel autark betrieben werden.

Es versteht sich, dass gemäß weiteren Varianten der erfindungsgemäße Schichtverbund bzw. die erfindungsgemäße elektromechanische Vorrichtung auch für andere Anwendungen verwendet werden kann, wie in strukturierten Drucksensoren für Tastaturen oder Touchpads, Beschleunigungssensoren, Mikrofonen, Lautsprechern, Ultraschallwandlern für Anwendungen in der Medizintechnik, der Meerestechnik oder zur Materialprüfung. Eine Anwendung als allgemein mechanische Drucksensoren ist auch in der Automatisierungs- und Automobiltechnik, dort beispielsweise als Lenkradsensoren oder Sitzsensoren, möglich.

Die hohe Sensitivität der bevorzugt eingesetzten Materialien ermöglicht zudem den Betrieb eines Sensors unterhalb einer nur leicht nachgiebigen, aber ansonsten harten Platte. Dies wird z.B. bei den vandalismussicheren Tastaturen mit einer dünnen Stahlplatte, wie sie z.B. von der Fa. Screentec (Finnland) hergestellt werden, ausgenutzt, könnte aber z.B. auch bei den erwähnten "smart-carpet"-Sensoranwendungen zum Einsatz kommen.

Ein weiterer Aspekt der Erfindung ist ein Verfahren zur Herstellung eines Schichtverbunds mit mindestens zwei zwischen einer ersten elektrisch leitfähigen Schicht und einer zweiten elektrisch leitfähigen Schicht angeordnete elektroaktive Schichten, wobei zwischen den mindestens zwei elektroaktiven Schichten zumindest eine elektrisch leitfähige Teilschicht angeordnet ist, wobei mindestens eine der mindestens zwei elektroaktiven Schichten eine Piezoschicht ist, und wobei mindestens eine weitere der mindestens zwei elektroaktiven Schichten eine dielektrische Elastomerschicht ist. Das Verfahren umfasst die Schritte Bereitstellen mindestens einer Piezoschicht, Bereitstellen mindestens einer dielektrischen Elastomerschicht, Verbinden der Piezoschicht mit der dielektrischen Elastomerschicht, wobei vor dem Verbinden der Piezoschicht mit der dielektrischen Elastomerschicht zumindest eine elektrisch leitfähige Schicht auf die Piezoschicht und/oder die dielektrische Elastomerschicht aufgebracht wird.

Bevorzugt kann beispielsweise die bereitgestellte Piezoschicht beidseitig mit einer elektrisch leitfähigen Schicht zumindest teilweise versehen werden. Dann kann die dielektrische Elastomerschicht bevorzugt unmittelbar mit zumindest einer dieser elektrisch leitfähigen Schichten verbunden werden. Ferner kann in einem weiteren Schritt die dielektrische Elastomerschicht mit einer weiteren elektrisch leitfähigen Schicht zumindest teilweise versehen werden. Es versteht sich, dass zunächst die dielektrische Elastomerschicht bevorzugt beidseitig mit elektrisch leitfähigen Schichten beschichtet werden kann. Anschließend kann dann die Piezoschicht aufgebracht werden.

Es versteht sich ferner, dass gemäß weiteren Varianten der Erfindung, weitere Piezoschichten und/oder weitere dielektrische Elastomerschichten in weiteren Schritten angeordnet werden können. Beispielsweise kann ein Schichtverbund umfassend zumindest eine Piezoschicht und eine dielektrische Elastomerschicht, die zwischen zwei elektrischen leitfähigen Schichten angeordnet sind, mit einem baugleichen Schichtverbund kaskadiert werden.

Des Weiteren kann gemäß einer ersten Ausführungsform des erfindungsgemäßen Verfahrens die dielektrische Elastomerschicht oder die Piezoschicht auf die elektrisch leitfähige Schicht auflaminiert werden. Dies führt in einer einfachen Weise zu einem besonders guten Kontakt zwischen den entsprechenden Schichten.

Gemäß einer bevorzugen Ausführungsform des erfindungsgemäßen Verfahrens kann die dielektrische Elastomerschicht oder die Piezoschicht zumindest teilweise mit einer leitfähigen Schicht bedruckt werden. Beispielsweise kann eine strukturierte Elektrode aufgedruckt werden. Ein Druckverfahren kann in einfacher Weise durchgeführt werden. Insbesondere ist eine Massenproduktion eines Schichtverbunds mit einer erhöhten Produktionsrate möglich.

Es gibt nun eine Vielzahl von Möglichkeiten, den erfindungsgemäßen Schichtverbund, die erfindungsgemäße elektromechanische Wandlervorrichtung und das erfindungsgemäße Verfahren zur Herstellung eines Schichtverbunds auszugestalten und weiterzuentwickeln. Hierzu sei einerseits verwiesen auf die den unabhängigen Patentansprüchen nachgeordneten Patentansprüche, andererseits auf die Beschreibung von Ausführungsbeispielen in Verbindung mit der Zeichnung. In der Zeichnung zeigt:
- Fig. 1: eine schematische Ansicht eines ersten Ausführungsbeispiels eines Schichtverbunds gemäß der vorliegenden Erfindung;
- Fig. 2: eine schematische Ansicht eines zweiten Ausführungsbeispiels eines Schichtverbunds gemäß der vorliegenden Erfindung;
- Fig. 3: eine schematische Ansicht eines dritten Ausführungsbeispiels eines Schichtverbunds gemäß der vorliegenden Erfindung;
- Fig. 4: eine schematische Ansicht eines ersten Ausführungsbeispiels einer elektromechanischen Wandlervorrichtung gemäß der vorliegenden Erfindung;
- Fig. 5: ein Flussdiagramm eines ersten Ausführungsbeispiels eines Verfahrens zum Herstellen eines Schichtverbunds gemäß der vorliegenden Erfindung;
- Fig. 6: ein Flussdiagramm eines zweiten Ausführungsbeispiels eines Verfahrens zum Herstellen eins Schichtverbundes gemäß der vorliegenden Erfindung.

Nachfolgend werden gleiche Bezugszeichen für gleiche Elemente verwendet.

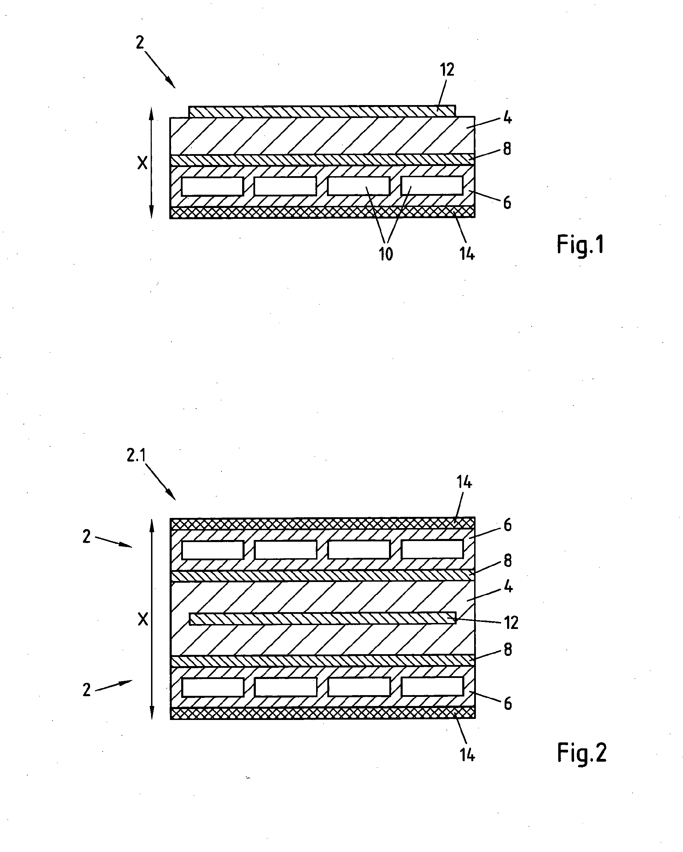

Figur 1 zeigt eine schematische Ansicht eines ersten Ausführungsbeispiels eines Schichtverbunds 2 gemäß der vorliegenden Erfindung. Der dargestellte Schichtverbund 2 umfasst zwei elektroaktive Schichten 4 und 6.

Die elektroaktive Schicht 4 ist eine dielektrische Elastomerschicht 4. Eine dielektrische Elastomerschicht 4 weist vorteilhafterweise eine relativ hohe Dielektrizitätszahl auf. Darüber hinaus weist eine dielektrische Elastomerschicht 4 vorteilhafterweise eine niedrige mechanische Steifigkeit auf. Dies führt zu möglichen Dehnungswerten von bis zu ca. 300 %. Eine dielektrische Elastomerschicht 4 kann insbesondere für eine Aktoranwendung eingesetzt werden.

Die zweite elektroaktive Schicht 6 ist als Piezoschicht 6 gebildet. Die dargestellte Piezoschicht 6 kann beispielsweise aus einem geeigneten Piezopolymer gebildet und kann z.B. eine Piezopolymerfolie bzw. Ferroelektretfolie sein. Die dargestellte Piezoschicht 6 weist eine Polymerschichtstruktur auf. Die Polymerschichtstruktur weist (gezielt) eingebrachte Hohlräume 10 auf.

Beispielsweise können zur Erzeugung der Hohlräume 10 eine planare Polymerschicht und eine wellenförmige Polymerschicht vorgesehen sein, die an den Wellentälern miteinander verbunden sind. Bei einer alternativen Ausgestaltung der Piezoschicht 6 können zwei planare Polymerschichten durch Stege verbunden sein, um die Hohlräume 10 zu formen.

Vor einer Anordnung der Piezoschicht 6 in dem Schichtverbund 2 kann die Piezoschicht 6 elektrisch aufgeladen werden. Beispielsweise kann die elektrische Aufladung oder Polung mittels direkter Aufladung oder Coronaentladung durchgeführt werden. Durch die Aufladung bzw. Polung weist die Piezoschicht 6 dauerhaft piezoelektrische Eigenschaften auf. Eine Piezoschicht 6 kann insbesondere für eine Sensoranwendung und/oder für Energy Harvesting eingesetzt werden.

Ferner kann der Figur 1 entnommen werden, dass zwischen der dielektrischen Elastomerschicht 4 und der Piezoschicht 6 zumindest eine elektrisch leitfähige Teilschicht 8 angeordnet ist. Es versteht sich, dass auch mehrere Schichten und/oder eine Vollschicht angeordnet sein können. Diese leitfähige Schicht 8 kann bevorzugt flächig mit der dielektrischen Elastomerschicht 4 und/oder der Piezoschicht 6 verbunden sein. Die elektrisch leitfähige Teilschicht 8 kann insbesondere als Elektrode ausgebildet sein. Beispielsweise kann die Elektrode aus einem Metall, einer Metalllegierung, einem leitfähigen Oligo- oder Polymer, einem leitfähigen Oxid und/oder einem mit leitfähigen Füllstoffen gefüllten Polymer sein.

Darüber hinaus sind die zwei elektroaktiven Schichten 4 und 6 zwischen zwei weiteren elektrisch leitfähigen Schichten 12 und 14 angeordnet.

Die Schicht 14 ist auf der Piezoschicht 6 aufgebracht und kann insbesondere nahezu die ganze Oberfläche der Piezoschicht 6 abdecken. Die elektrisch leitfähige Schicht 12 kann auf der dielektrischen Elastomerschicht 4 aufgebracht sein. Beispielsweise kann eine segmentierte Schicht 12 vorgesehen sein. Bevorzugt sind auch die elektrisch leitfähigen Schichten 12 und 14 metallbasiert gebildet.

Der hybride Schichtverbund 2 umfassend mindestens eine dielektrische Elastomerschicht 4 und mindestens eine Piezoschicht 6 zeichnet sich insbesondere dadurch aus, dass drei Funktionen in einem einzigen Schichtverbund kombiniert und zur Verfügung gestellt werden können. Insbesondere werden die Funktionen Aktorik, Energy Harvesting und Sensorik durch einen einzigen Schichtverbund bereitgestellt.

Während sich bei einer dielektrischen Elastomerschicht die Fläche der Schicht in Folge einer Beaufschlagung mit einem elektrischen Feld ändert, ändert sich bei einer Ferroelektretfolie im Wesentlichen (lediglich) die Dicke der Schicht. Die Anordnung beider Schichtarten führt dazu, dass eine Formänderung im Wesentlichen nur in einer Richtung X senkrecht zur Oberfläche der Schichten 4 und 6 durchführbar ist. So kann die Dicke des Schichtverbunds 2 verändert, also vergrößert oder verkleinert werden, ohne dass eine wesentliche Formänderung in eine andere Richtung möglich ist. Es sei angemerkt, dass in Abhängigkeit der Anwendung eine Formänderung in eine andere Richtung zulässig sein kann.

Des Weiteren wird in der Figur 2 ein weiteres Ausführungsbeispiel eines Schichtverbunds 2.1 gemäß der vorliegenden Erfindung gezeigt. Wie der Figur 2 entnommen werden kann, weist der Schichtverbund 2.1 zwei Schichtverbunde 2 gemäß der Figur 1 auf. Insbesondere sind die Schichtverbunde 2 spiegelverkehrt übereinander angeordnet. Es versteht sich, dass nur eine elektrisch leitfähige Schicht 12 vorgesehen sein kann oder die beiden Schichten 12 der Schichtverbunde 2 miteinander zu einer Schicht 12 verbunden werden können.

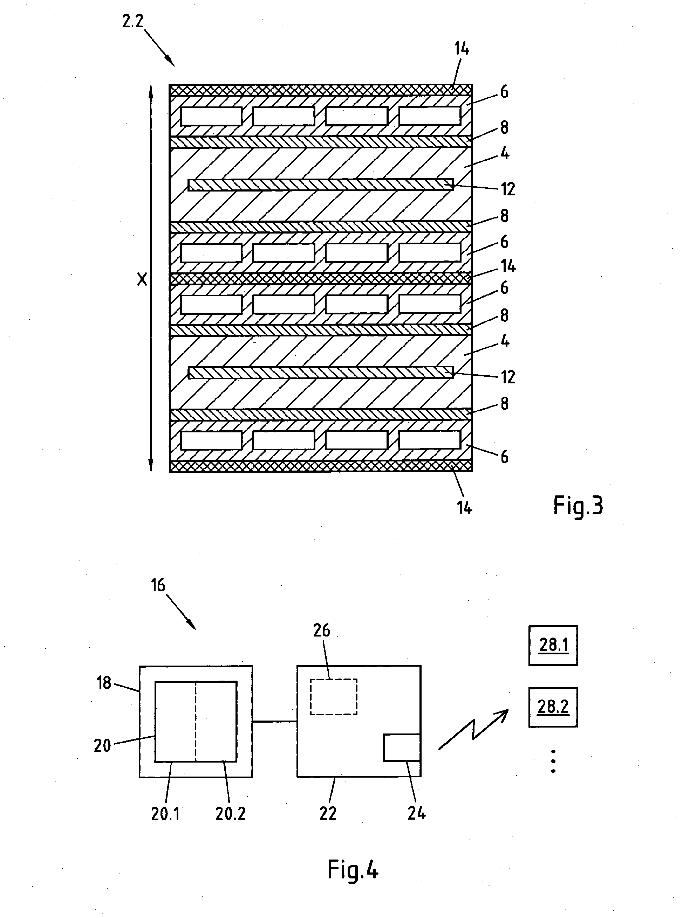

Figur 3 zeigt ein drittes Ausführungsbeispiel eines Schichtverbunds 2.2 gemäß der vorliegenden Erfindung. Der Schichtverbund 2.2 umfasst zwei beispielsweise kaskadierte Schichtverbunde 2.1 gemäß der Figur 2. Es versteht sich, dass weitere Kaskadierungen möglich sind. Ferner versteht es sich, dass nur eine Schicht 14 vorgesehen sein kann oder die beiden Schichten 14 der Schichtverbunde 2.2 miteinander zu einer Schicht 14 verbunden werden können.

Es versteht sich auch, dass gemäß anderen Varianten der vorliegenden Erfindung eine Verbundschicht in beliebig anderer Form aufgebaut sein kann, solange zumindest eine dielektrische Elastomerschicht und zumindest eine Piezoschicht vorgesehen sind. Beispielsweise können zwei oder mehr Piezoschichten mit einer (oder mehr) Elastomerschicht(en) vorgesehen sein.

Figur 4 zeigt eine vereinfachte Ansicht eines Ausführungsbeispiels einer elektromechanischen Wandlervorrichtung 16 gemäß der vorliegenden Erfindung. Die elektromechanischen Wandlervorrichtung 16 kann beispielsweise als Schalter, wie einem Tastsensor, einem Flachsensor, oder als intelligentes Fußbodenelement ausgebildet sein. Insbesondere kann die Wandlervorrichtung 16 in einem Gebäudeautomationssystem eingesetzt werden. So kann die Wandlervorrichtung 16 zur Ansteuerung von Heizungen, der Beleuchtung, Beschattungseinrichtungen, etc. oder in der Gerontologie (Aktivitäts- und Falldetektion) oder in der Sicherheitstechnik eingesetzt werden.

Die elektromechanische Wandlervorrichtung 16 umfasst einen Schichtverbund 18, der zu Gunsten einer besseren Darstellung nicht detailliert gezeigt ist. Beispielsweise kann ein Schichtverbund 2, 2.1, oder 2.2 gemäß den Figuren 1 bis 3 eingesetzt werden.

Die Ausgestaltung des Schichtverbunds 18 kann sich insbesondere nach der Anwendung der elektromechanischen Wandlervorrichtung 16 richten.

Tastsensoren in konventioneller Bauform können bevorzugt mit zwei oder mehr Piezoschichten 6 gebildet sein. Dies ermöglicht Betätigungswege von z.B. bis zu ca. 2 mm. Darüber hinaus ermöglichen zwei oder mehr Piezoschichten 6, dass mechanische Kräfte von z.B. bis zu ca. 5 N in elektrische Energie gewandelt werden können.

Flachsensoren können hingegen eine möglichst geringe Schichtenanzahl und/oder Schichten mit geringen Dicken aufweisen. Beispielsweise kann ein Flachsensor eine Piezoschicht und eine dielektrische Elastomerschicht aufweisen. Bei derartigen Flachsensoren werden (unmerkliche) Betätigungswege von weniger als 500 µm erzielt. Ein Flachsensor kann mit einer Kraft von weniger als 1 N betätigt werden. Insbesondere durch eine Beaufschlagung der dielektrischen Elastomerschicht mit einer Spannung kann eine taktile Rückmeldung als Bestätigung für eine Bedienung des Flachsensors bereitgestellt werden. Neben einer taktilen Rückmeldung können Rückmeldungen von dem zu aktuierenden Element an den Benutzer übertragen werden. Beispielsweise kann dies über ein Funksignal erfolgen.

Eine weitere Anwendungsmöglichkeit der Wandlervorrichtung 16 ist ein Fußbodensensor, wie ein intelligentes Fußbodenelement. Beispielsweise kann die Wandlervorrichtung 16 in Form einer Kachel gebildet sein, welche beispielsweise eine Fläche von 100 cm² oder mehr aufweisen kann. Die Kachel kann ferner eine Tiefe von ca. 1 mm aufweisen. Dieses Fußbodenelement kann insbesondere mehrere Piezoschichten aufweisen. Eine Bedienkraft von 100 N und mehr ist möglich. Hierdurch lassen sich Energiemengen von mehr als 300 µJ erzielen.

Der Schichtverbund 18, insbesondere die obere Elektrode, kann mit einer Bedienoberfläche 20 verbunden sein. Unter einer Bedienoberfläche ist die Fläche zu verstehen, die von einem Benutzer aktuiert, also beispielsweise mit einem Druck beaufschlagt werden kann, um eine gewünschte Funktion zu veranlassen.

Grundsätzlich kann die Bedienfläche 20 beliebig gestaltet sein. Beispielsweise kann die Bedienfläche 20 ein erstes Segment 20.1 und ein zweites Segment 20.2 aufweisen, die sich z.B. optisch unterscheiden können. Das erste Segment 20.1 kann für eine erste Aktion vorgesehen sein und das zweite Segment 20.2 für eine zweite Aktion. Es versteht sich, dass auch mehr als nur zwei Segmente oder auch nur ein Segment vorgesehen sein können.

Mit dem Schichtverbund 18 kann eine Schaltungseinrichtung 22 verbunden werden. Die Schaltungseinrichtung 22 kann mit den Elektroden des Schichtverbunds 18 verbunden sein. Die Schaltungseinrichtung 22 und der Schichtverbund 18 können in einem (nicht dargestellten) Gehäuse integriert sein oder modular aufgebaut sein. Ein modularer Aufbau ermöglicht beispielsweise eine flexible Zusammenstellung unterschiedlicher Elemente zur Erzielung unterschiedlicher Funktionen.

Die Schaltungseinrichtung 22 kann dazu eingerichtet sein, in Abhängigkeit von elektrischen Signalen, die auf eine Betätigung der elektromechanischen Wandlervorrichtung zurückzuführen sind, Aktionen zu veranlassen. Beispielsweise kann ein Sendeelement 24 in der Schaltungseinrichtung 22 vorgesehen sein. Dieses Sendeelement 24 kann bei Empfang eines elektrischen Signals von dem Schichtverbund 18 veranlassen, eine Information auszusenden. Insbesondere kann ein Funksignal ausgesendet werden. Es versteht sich, dass alternativ oder zusätzlich auch eine drahtgebundene Schnittstelle vorgesehen sein kann.

Die ausgesendete Information kann von einem oder mehreren Empfängern 28.1, 28.2 empfangen werden. Die Empfänger 28.1, 28.2 können Aktoren umfassen oder mit Aktoren verbunden sein, um (nicht dargestellte) Verbraucher in Abhängigkeit der empfangenen Information zu anzusteuern. Wie bereits beschrieben wurde, kann beispielsweise eine Heizung oder dergleichen angesteuert werden. Ferner kann die empfangene Information, wie beispielsweise eine eindeutige Kennung, Rückschlüsse auf die Position eines Bedieners geben.

Eine Möglichkeit, die Schaltungseinrichtung 22 mit Energie beispielsweise zur Erzeugung eines Funksignals zu versorgen, besteht darin, die mechanische auf die Bedienfläche 20 wirkende Kraft zu nutzen. Wie bereits beschrieben wurde, eignen sich insbesondere Piezoschichten 6 für Energy Harvesting. Beispielsweise bei dem oben beschriebenen Tastsensor kann die mechanische Energie, die in elektrische Energie gewandelt wird, ausreichen, um ein Funksignal zu senden. Insbesondere ist es möglich, die erzeugte elektrische Energie zu sammeln und beispielsweise mittels eines Kondensators, eines Superkondensators oder einer Batterie zwischenzuspeichern. Wenn eine ausreichende Energiemenge zur Durchführung einer Aktion gespeichert worden ist, dann kann diese ausgeführt werden. Eine autarke elektromechanische Wandlervorrichtung 16 kann bereitgestellt werden.

Die Schaltungseinrichtung 22 kann optional einen Energiespeicher 26, wie eine Batterie, umfassen. Ein Energiespeicher 26 kann insbesondere dann erforderlich sein, wenn die durch die mechanische Kraftänderung erzeugbare elektrische Energie für einen autarken Betrieb der Schaltungseinrichtung 22 nicht ausreicht. Dies ist beispielsweise bei Flachsensoren der Fall, die z.B. nur eine Piezoschicht 6 umfassen können. Unter Berücksichtigung der Bauraumverhältnisse kann eine Energie von beispielsweise ca. 100 pJ erzeugt werden. Diese Energie kann genutzt werden, um die Schaltungseinrichtung 22 aus einem Ruhezustand in einen Betriebszustand zu versetzen, also aufzuwecken. Dann kann die Schaltungseinrichtung 22 durch den Energiespeicher 26 versorgt werden, um zumindest eine gewünschte Funktion auszuführen. Anschließend kann die Schaltungseinrichtung bevorzugt automatisch wieder in den Ruhezustand versetzt werden. Der Ruhestromverbrauch liegt bei einer derartigen elektromechanischen Wandlervorrichtung 16 in der Nähe der Selbstentladung des Energiespeichers 26. Die Aufweckenergie kann ausschließlich durch die mechanische Kraftänderung erzeugt werden. Eine Lebensdauer von beispielsweise mehr als 20 Jahren (beispielsweise bei Einsatz von Lithium-Mangandioxid-Zellen) kann erzielt werden.

Ferner kann ein Energiespeicher erforderlich sein, wenn die auf von der Schaltungseinrichtung durchzuführenden Operationen mehr Energie benötigen, als durch die mechanische Kraftänderung bereitgestellt werden kann. Es versteht sich hierbei, dass die Schaltungseinrichtung weitere Komponenten, wie einen Prozessor, Speicher oder Schnittstellen umfassen kann.

Darüber hinaus kann die Schaltungseinrichtung 22 mit zumindest den Elektroden einer dielektrischen Elastomerschicht 4 derart verbunden sein, dass für eine Aktoranwendung zur Erzeugung einer Dickenänderung ein elektrisches Feld angelegt werden kann. Beispielsweise kann einem Benutzer durch die Aktorfunktion der elektromechanischen Wandlervorrichtung 16 eine taktile Rückmeldung gegeben werden. So kann ein Wechselfeld mit einer Frequenz von 200 bis 250 Hz erzeugt werden. Durch dieses Wechselfeld kann z.B. eine Dickenänderung der elektromechanischen Wandlervorrichtung 16 von zumindest 0,1 µm, bevorzugt 10 µm, generiert werden. Es ist erkannt worden, dass gerade bei diesen Parameterwerten der menschliche Finger besonders empfindlich ist.

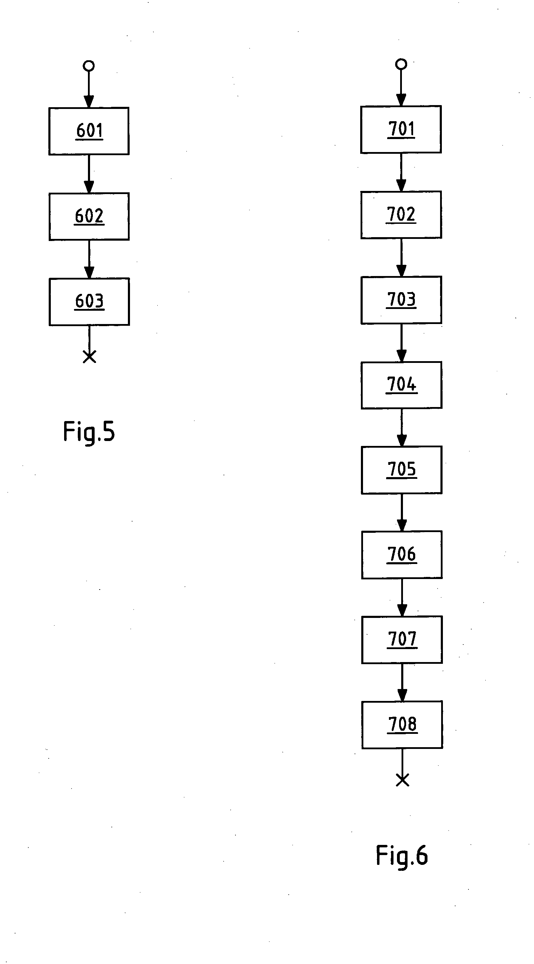

Figur 5 zeigt ein erstes Ausführungsbeispiel eines Verfahrens zur Herstellung eines Schichtverbunds gemäß der Erfindung.

In einem ersten Schritt 601 kann eine Piezoschicht 6, wie beispielsweise eine Ferroelektretfolie, bereitgestellt werden. In einem zweiten Schritt 602 kann auf zumindest einer Seite der Piezoschicht 6 eine elektrisch leitfähige Teilschicht 8 beispielsweise durch Beschichten aufgebracht werden. Dann kann in einem Schritt 603 eine bereitgestellte dielektrische Elastomerschicht 4 auf die zumindest eine elektrisch leitfähige Schicht 8 aufgebracht, beispielsweise auflaminiert werden. In einfacher Weise kann ein Schichtverbund 2.1 mit einer Piezoschicht 4 und einer dielektrische Elastomerschicht 6 hergestellt werden.

Es versteht sich, dass die Reihenfolge der Verarbeitungsschritte grundsätzlich beliebig sein kann. Insbesondere kann alternativ in einem ersten Schritt eine dielektrische Elastomerschicht 4 bereitgestellt werden, die dann zunächst mit einer elektrisch leitfähigen Schicht 8 versehen werden kann. Anschließend kann dann eine Piezoschicht 6 angeordnet werden.

In Figur 6 wird ein weiteres Ausführungsbeispiel eines Verfahrens zur Herstellung eines Schichtverbunds gemäß der Erfindung dargestellt.

In einem ersten Schritt 701 kann zunächst eine Piezoschicht 6 wie eine Ferroelektretfolie, bereitgestellt werden.

In einem zweiten Schritt 702 kann die Piezoschicht 6 bevorzugt beidseitig mit elektrisch leitfähigen Schichten 8, 14 beschichtet werden. Insbesondere kann die Piezoschicht 6 vollflächig auf beiden Oberflächen beschichtet werden. Neben der vollflächigen Beschichtung kann die Piezoschicht auch nur teilweise mit einer elektrisch leitfähigen Schicht 8 bzw. 14 beschichtet werden. Eine strukturierte Elektrode kann erzeugt werden. Insbesondere können hierdurch aktive und passive Bereiche geschaffen werden.

Dann kann in Schritt 703 eine dielektrische Elastomerschicht 4, insbesondere eine Elastomerfolie, auf die obere oder untere elektrisch leitfähige Schicht 8, 14 auflaminiert werden.

Es kann bevorzugt sein, dass die dielektrische Elastomerschicht 4 (nur) teilweise auflaminiert wird. Dies kann insbesondere aufgrund der unterschiedlichen Ausdehnungen der dielektrischen Elastomerschicht 4 und der Piezoschicht 6 vorteilhaft sein.

Die dielektrische Elastomerschicht 4 kann wiederum im nächsten Schritt 704 auf ihrer Oberseite mit einer bevorzugt segmentierten elektrisch leitfähigen Schicht 12, wie einer strukturierten Elektrode, bedruckt werden. Eine strukturierte Elektrode zeichnet sich insbesondere durch passive und aktive Bereiche aus. Hierdurch kann im späteren Betrieb des Schichtverbunds 2 die Isolation zur Masselage sichergestellt werden.

Darüber hinaus kann dieser Schichtverbund 2 mit einem baugleichen Schichtverbund 2 spiegelverkehrt verbunden werden, insbesondere laminiert werden (Schritt 706). Beispielsweise können die Schichten 12 miteinander verbunden werden.

Optional können Schichtverbunde durch Kaskadierung von zwei oder mehreren dieser Schichtverbunde 2.1 hergestellt werden (Schritt 707). Beispielsweise können zwei Schichtverbunde 2.1 durch Stapeln, Verkleben oder Laminieren kaskadiert werden.

In einem weiteren Schritt 708 kann der hergestellte Schichtverbund in eine gewünschte Form mit vorgebbaren Maßen gebracht werden. Beispielsweise können einzelne Schichtverbunde ausgestanzt werden.

Der hergestellte Schichtverbund kann dann in einem weiteren Verfahren elektrisch mit einer Schaltungseinrichtung verbunden werden. Insbesondere kann die Schaltungseinrichtung mit den als Elektroden ausgebildeten elektrisch leitfähigen Schichten verbunden werden.

Es versteht sich auch hier, dass gemäß anderen Varianten der vorliegenden Erfindung eine andere Reihenfolge der Schritte möglich ist und diese insbesondere von der konkreten Ausgestaltung des Schichtverbunds abhängen kann. Beispielsweise können zunächst zwei gleichartige Schichten miteinander verbunden werden und erst dann eine andere Schichtenart angebracht werden.

## Patentansprüche

1. Schichtverbund (2, 2.1, 2.2, 18), umfassend:
- mindestens zwei zwischen einer ersten elektrisch leitfähigen Schicht (12) und einer zweiten elektrisch leitfähigen Schicht (14) angeordnete elektroaktive Schichten (4, 6),
- wobei zwischen den mindestens zwei elektroaktiven Schichten (4, 6) zumindest eineelektrisch leitfähige Teilschicht (8) angeordnet ist, und
- wobei mindestens eine der mindestens zwei elektroaktiven Schichten (4, 6) eine Piezoschicht (6) ist,
**dadurch gekennzeichnet,**
**dass** mindestens eine weitere der mindestens zwei elektroaktiven Schichten (4, 6) eine dielektrische Elastomerschicht (4) ist.

2. Schichtverbund (2, 2.1, 2.2, 18) nach Anspruch 1, **dadurch gekennzeichnet,**
- **dass** mindestens eine weitere Piezoschicht (6) zwischen der ersten elektrisch leitfähigen Schicht (12) und der zweiten elektrisch leitfähigen Schicht (14) angeordnet ist,
und/oder
- **dass** mindestens eine weitere dielektrische Elastomerschicht (4) zwischen der ersten elektrisch leitfähigen Schicht (12) und der zweiten elektrisch leitfähigen Schicht (14) angeordnet ist.

3. Schichtverbund (2, 2.1, 2.2, 18) nach Anspruch 1 oder 2, **dadurch gekennzeichnet, dass** die Piezoschicht (6) eine Ferroelektretschicht ist.

4. Schichtverbund (2, 2.1, 2.2, 18) nach einem der vorherigen Ansprüche, **dadurch gekennzeichnet,**
- **dass** die Piezoschicht (6) ein Material umfasst, das ausgewählt ist aus der Gruppe umfassend Polycarbonat, perfluorierte oder teilfluorierte Polymere und CoPolymere, Polytetrafluorethylen, Fluorethylenpropylen, Perfluoralkoxyethylen, Polyester, Polyethylenterephthalat, Polyethylennaphthalat, Polyimid, Polyetherimid, Polyether, Polymethyl(meth)acrylat, Cyclo-Olefin-Polymere, Cyclo-Olefin-Copolymere und/oder Polyolefine,
und/oder
- **dass** die dielektrische Elastomerschicht (4) ein Material umfasst, das ausgewählt ist aus der Gruppe umfassend Polyurethan-Elastomere, Silikon-Elastomere und/oder Acrylat-Elastomere.

5. Elektromechanische Wandlervorrichtung (16) umfassend einen Schichtverbund (2, 2.1, 2.2, 18) nach einem der vorherigen Ansprüchen 1 bis 4.

6. Elektromechanische Wandlervorrichtung (16) nach Anspruch 5, **dadurch gekennzeichnet, dass** der Schichtverbund (2, 2.1, 2.2, 18) mit einer Bedienoberfläche (20) verbunden ist, derart, dass eine auf die Bedienoberfläche (20) wirkende mechanische Kraftänderung in ein elektrisches Signal und/oder in elektrische Energie wandelbar ist.

7. Elektromechanische Wandlervorrichtung (16) nach Anspruch 5 oder 6, **dadurch gekennzeichnet, dass** eine mit dem Schichtverbund (2, 2.1, 2.2, 18) verbindbare elektrische Schaltungseinrichtung (22) vorgesehen ist.

8. Elektromechanische Wandlervorrichtung (16) nach einem der vorherigen Ansprüche 5 bis 7, **dadurch gekennzeichnet,**
- **dass** die Schaltungseinrichtung (22) autark durch die in elektrische Energie gewandelte mechanische Energie betreibbar ist,
oder
- **dass** die Schaltungseinrichtung (22) eine Energieversorgung (26) umfasst, wobei die Schaltungseinrichtung (22) durch die in elektrische Energie gewandelte mechanische Energie aus einem Ruhezustand in einen Betriebszustand versetzbar ist.

9. Elektromechanische Wandlervorrichtung (16) nach einem der vorherigen Ansprüche 5 bis 8, **dadurch gekennzeichnet, dass** die Schaltungseinrichtung (22) ein Sendeelement (24) zum Senden eines Signals umfasst.

10. Elektromechanische Wandlervorrichtung (16) nach Anspruch 9, **dadurch gekennzeichnet, dass** für eine taktile Rückmeldung zumindest die eine dielektrische Elastomerschicht (4) mit einer Spannung beaufschlagt wird, derart, dass eine Dickenänderung des Schichtverbunds (2, 2.1, 2.2, 18) von zumindest 0,1 µm mit einer vorgebbaren Frequenz erzeugt wird.

11. Elektromechanische Wandlervorrichtung (16) nach einem der Ansprüche 5 bis 10, **dadurch gekennzeichnet, dass** die Bedienoberfläche (20) ein erstes Segment (20.1) zur Auslösung einer ersten Aktion und mindestens ein zweites Segment (20.2) zur Auslösung einer zweiten Aktion umfasst.

12. Elektromechanische Wandlervorrichtung (16) nach einem der Ansprüche 5 bis 11, **dadurch gekennzeichnet, dass** die elektromechanische Wandlervorrichtung (16) ein mechanischer Drucksensor, insbesondere Tastsensor, ein Flachsensor oder ein Fußbodensensor ist.

13. Verfahren zur Herstellung eines Schichtverbunds (2, 2.1, 2.2, 18) mit mindestens zwei zwischen einer ersten elektrisch leitfähigen Schicht (12) und einer zweiten elektrisch leitfähigen Schicht (14) angeordnete elektroaktive Schichten (4, 6), wobei zwischen den mindestens zwei elektroaktiven Schichten (4, 6) zumindest eineelektrisch leitfähige Teilschicht (8) angeordnet ist, wobei mindestens eine der mindestens zwei elektroaktiven Schichten (4, 6) eine Piezoschicht (6) ist, und wobei mindestens eine weitere der mindestens zwei elektroaktiven Schichten (4, 6) eine dielektrische Elastomerschicht (4) ist, umfassend:
- Bereitstellen der mindestens einen Piezoschicht (6),
- Bereitstellen der mindestens einen dielektrischen Elastomerschicht (4),
- Verbinden der Piezoschicht (6) mit der dielektrischen Elastomerschicht (4),
- wobei vor dem Verbinden der Piezoschicht (6) mit der dielektrischen Elastomerschicht (4) zumindest die eine elektrisch leitfähige Teilschicht (8) auf die Piezoschicht (6) und/oder die dielektrische Elastomerschicht (4) aufgebracht wird.

14. Verfahren nach Anspruch 13, **dadurch gekennzeichnet, dass** die dielektrische Elastomerschicht (4) oder die Piezoschicht auf die elektrisch leitfähige Teilschicht (8) auflaminiert wird.

15. Verfahren nach einem der Ansprüche 13 oder 14, **dadurch gekennzeichnet, dass** die dielektrische Elastomerschicht (4) oder die Piezoschicht (6) zumindest teilweise mit der leitfähigen Schicht (12, 14) bedruckt wird.

## Claims

1. Multi-layer composite (2, 2.1, 2.2, 18), comprising:
- at least two electro active layers (4, 6) positioned between a first electrically conductive layer (12) and a second electrically conductive layer (14),
- wherein at least one electrically conductive sub-layer (8) is positioned between the at least two electro active layers (4,6), and
- wherein at least one of the at least two electro active layers (4, 6) is a piezo layer (6),
**characterised in that**
at least one other of the at least two electroactive layers (4, 6) is a dielectric elastomer layer (4).

2. Multi-layer composite (2, 2.1, 2.2, 18) according to claim 1, **characterised in that**
- at least one further piezo layer (6) is positioned between the first electrically conductive layer (12) and the second electrically conductive layer (14),
and/or
- at least one further dielectric elastomer layer (4) is positioned between the first electrically conductive layer (12) and the second electrically conductive layer (14).

3. Multi-layer composite (2, 2.1, 2.2, 18) according to claim 1 or 2, **characterised in that** the piezo layer (6) is a ferro electret layer.

4. Multi-layer composite (2, 2.1, 2.2, 18) according to one of the preceding claims, **characterised in that**
- the piezo layer (6) comprises a material selected from the group comprising polycarbonate, perfluorinated or partially fluorinated polymers and copolymers, polytetrafluoroethylene, fluoroethylene propylene, perfluoroalkoxyethylene, polyester, polyethylene terephthalate, polyethylene naphthalate, polyimide, polyetherimide, polyether, polymethyl (meth)acrylate, cyclic olefin polymers, cyclic olefin copolymers and/or polyolefins,
and/or
- the dielectric elastomer layer (4) comprises a material selected from the group comprising polyurethane elastomers, silicone elastomers and/or acrylate elastomers.

5. Electromechanical converter device (16) comprising a multi-layer composite (2, 2.1, 2.2, 18) according to one of the preceding claims 1 to 4.

6. Electromechanical converter device (16) according to claim 5, **characterised in that** the multi-layer composite (2, 2.1,2.2,18) is connected to a user interface (20) in such a way that a mechanical force change acting on the user interface (20) can be converted into an electrical signal and/or into electrical energy.

7. Electromechanical converter device (16) according to claim 5 or 6, **characterised in that** an electrical circuit arrangement (22) connectable to the multi-layer composite (2, 2.1, 2.2, 18) is provided.

8. Electromechanical converter device (16) according to one of the preceding claims 5 to 7, **characterised in that**
- the circuit arrangement (22) can be operated autonomously by the mechanical energy converted into electrical energy,
or
- the circuit arrangement (22) comprises a power supply (26) wherein the circuit arrangement (22) can be shifted from an idle state to an operating state by the mechanical energy converted into electrical energy.

9. Electromechanical converter device (16) according to one of the preceding claims 5 to 8, **characterised in that** the circuit arrangement (22) comprises a transmission element (24) for transmitting a signal.

10. Electromechanical converter device (16) according to claim 9, **characterised in that** for a tactile feedback a voltage is applied to at least the one dielectric elastomer layer (4) in such a way that a change in thickness of the multi-layer composite (2, 2.1, 2.2, 18) of at least 0.1 flm is generated with a predefinable frequency.

11. Electromechanical converter device (16) according to one of claims 5 to 10, **characterised in that** the user interface (20) comprises a first segment (20.1) for triggering a first action and at least a second segment (20.2) for triggering a second action.

12. Electromechanical converter device (16) according to one of claims 5 to 11, **characterised in that** the electromechanical converter device (16) is a mechanical pressure sensor, in particular a tactile sensor, a flat sensor or a floor sensor.

13. Method for producing a multi-layer composite (2, 2.1, 2.2,18) having at least two electro active layers (4, 6) positioned between a first electrically conductive layer (12) and a second electrically conductive layer (14), wherein at least one electrically conductive sub-layer (8) is positioned between the at least two electro active layers (4, 6), wherein at least one of the at least two electro active layers (4,6) is a piezo layer (6), and wherein at least one other of the at least two electroactive layers (4, 6) is a dielectric elastomer layer (4), comprising:
- provision of the at least one piezo layer (6),
- provision of the at least one dielectric elastomer layer (4),
- connection of the piezo layer (6) to the dielectric elastomer layer (4),
- wherein before connecting the piezo layer (6) to the dielectric elastomer layer (4) at least the one electrically conductive sub-layer (8) is applied to the piezo layer (6) and/or to the dielectric elastomer layer (4).

14. Method according to claim 13, **characterised in that** the dielectric elastomer layer (4) or the piezo layer is laminated to the electrically conductive sub-layer (8).

15. Method according to one of claims 13 or 14, **characterised in that** the dielectric elastomer layer (4) or the piezo layer (6) is printed at least in part with the conductive layer (12, 14).

## Revendications

1. Composite stratifié (2, 2.1, 2.2, 18), comprenant :
- au moins deux couches électroactives (4, 6) intercalées entre une première couche électriquement conductrice (12) et une deuxième couche électriquement conductrice (14),
- au moins une couche partielle électriquement conductrice (8) étant intercalée entre les au moins deux couches électroactives (4, 6), et
- au moins une des au moins deux couches électroactives (4, 6) étant une couche piézoélectrique (6),
**caractérisé en ce que**
au moins une autre des au moins deux couches électroactives (4, 6) est une couche élastomère diélectrique (4).

2. Composite stratifié (2, 2.1, 2.2, 18) selon la revendication 1, characterise
- en ce qu'au moins une autre couche piézoélectrique (6) est intercalée entre la première couche électriquement conductrice (12) et la deuxième couche électriquement conductrice (14),
et/ou
- en ce qu'au moins une autre couche élastomère diélectrique (4) est intercalée entre la première couche électriquement conductrice (12) et la deuxième couche électriquement conductrice (14).

3. Composite stratifié (2, 2.1, 2.2, 18) selon la revendication 1 ou la revendication 2, **caractérisé en ce que** la couche piézoélectrique (6) est une couche à ferroélectret.

4. Composite stratifié (2, 2.1, 2.2, 18) selon l'une des revendications précédentes, characterise
- en ce que la couche piézoélectrique (6) comprend un matériau sélectionné dans le groupe composé de polycarbonate, de polymères et copolymères perfluorés ou partiellement fluorés, de polytétrafluoroéthylène, de fluoroéthylène propylène, perfluoralcoxyéthylène, polyester, polyéthylène téréphtalate, polyéthylène naphtalate, polyimide, polyétherimide, polyéther, polyméthyle(méth)acrylate, cyclo-oléfine-polymères, cyclo-oléfine-copolymères et/ou polyoléfines,
et/ou
- en ce que la couche élastomère diélectrique (4) comprend un matériau sélectionné dans le groupe composé d'élastomères de polyuréthane, élastomères de silicone et/ou élastomères d'acrylate.

5. Dispositif convertisseur électromécanique (16) comprenant un composite stratifié (2, 2.1, 2.2, 18) selon l'une des revendications 1 à 4.

6. Dispositif convertisseur électromécanique (16) selon la revendication 5, **caractérisé en ce que** le composite stratifié (2, 2.1, 2.2, 18) est relié à une surface de commande (20), de manière à pouvoir convertir en signal électrique et/ou en énergie électrique une variation de force mécanique agissant sur la surface de commande (20).

7. Dispositif convertisseur électromécanique (16) selon la revendication 5 ou la revendication 6, **caractérisé en ce qu'**il est prévu un moyen de circuit électrique (22) pouvant être relié au composite stratifié (2, 2.1, 2.2, 18).

8. Dispositif convertisseur électromécanique (16) selon l'une des revendications 5 à 7, characterise
- en ce que le moyen de circuit électrique (22) peut être commandé de manière autarcique par l'énergie mécanique convertie en énergie électrique,
ou
- en ce que le moyen de circuit électrique (22) comprend une alimentation en énergie (26), le moyen de circuit électrique (22) pouvant être commuté d'un état de repos vers un état de service par l'énergie mécanique convertie en énergie électrique.

9. Dispositif convertisseur électromécanique (16) selon l'une des revendications 5 à 8, **caractérisé en ce que** le moyen de circuit électrique (22) comprend un élément émetteur (24) pour l'émission d'un signal.

10. Dispositif convertisseur électromécanique (16) selon la revendication 9, **caractérisé en ce que** pour un retour tactile, une tension est appliquée au moins à la première couche élastomère diélectrique (4), de manière à générer une variation d'épaisseur du composite stratifié (2, 2.1, 2.2, 18) d'au moins 0,1 µm avec une fréquence définissable.

11. Dispositif convertisseur électromécanique (16) selon l'une des revendications 5 à 10, **caractérisé en ce que** la surface de commande (20) comprend un premier segment (20.1) pour le déclenchement d'une première action et au moins un deuxième segment (20.2) pour le déclenchement d'une deuxième action.

12. Dispositif convertisseur électromécanique (16) selon l'une des revendications 5 à 11, **caractérisé en ce que** le dispositif convertisseur électromécanique (16) est un capteur de pression mécanique, en particulier une touche sensorielle, un capteur plat ou un capteur au sol.

13. Procédé de fabrication d'un composite stratifié (2, 2.1, 2.2, 18) avec au moins deux couches électroactives (4, 6) intercalées entre une première couche électriquement conductrice (12) et une deuxième couche électriquement conductrice (14), au moins une couche partielle électriquement conductrice (8) étant intercalée entre les au moins deux couches électroactives (4, 6), au moins une des au moins deux couches électroactives (4, 6) étant une couche piézoélectrique (6), et au moins une autre des au moins deux couches électroactives (4, 6) étant une couche élastomère diélectrique (4), comprenant :
- la préparation de la ou des couches piézoélectriques (6),
- la préparation de la ou des couches élastomères diélectriques (4),
- le raccordement de la couche piézoélectrique (6) à la couche élastomère diélectrique (4),
- au moins la première couche partielle électriquement conductrice (8) étant appliquée sur la couche piézoélectrique (6) et/ou la couche élastomère diélectrique (4) avant le raccordement de la couche piézoélectrique (6) à la couche élastomère diélectrique (4).

14. Procédé selon la revendication 13, **caractérisé en ce que** la couche élastomère diélectrique (4) ou la couche piézoélectrique sont stratifiées sur la couche partielle électriquement conductrice (8).

15. Procédé selon la revendication 13 ou la revendication 14, **caractérisé en ce que** la couche élastomère diélectrique (4) ou la couche piézoélectrique (6) sont imprimées au moins partiellement avec la couche conductrice (12, 14).
